Europäisches Patentamt

European Patent Office

Office européen des brevets

(19)

(11) Numéro de publication: **0 030 178**
**A2**

(12) ## DEMANDE DE BREVET EUROPEEN

(21) Numéro de dépôt: **80401623.6**

(22) Date de dépôt: **13.11.80**

(51) Int. Cl.³: **H 01 L 29/10**
**H 01 L 29/06, H 01 L 29/80**

(30) Priorité: **04.12.79 FR 7929764**

(43) Date de publication de la demande:
**10.06.81 Bulletin 81/23**

(84) Etats Contractants Désignés:
**DE GB IT NL**

(71) Demandeur: **THOMSON-CSF**
**173, Boulevard Haussmann**
**F-75360 Paris Cedex 08(FR)**

(72) Inventeur: **Bert, Alain**
**THOMSON-CSF SCPI 173, Bld Haussmann**
**F-75360 Paris Cedex 08(FR)**

(74) Mandataire: **Benichou, Robert et al,**
**"THOMSON-CSF" - SCPI 173 bld Haussmann**
**F-75360 Paris Cedex 08(FR)**

(54) **Transistor à effet de champ, procédé de fabrication de celui-ci, et amplificateur comprenant un tel transistor.**

(57) L'invention concerne un transistor à effet de champ.

Afin d'augmenter la tension drain-source applicable au transistor, et par là, les niveaux de puissance réalisables, l'invention prévoit de ménager une marche dans l'interface (15) entre la couche semi-conductrice (14) et le substrat (13), de façon que l'épaisseur de cette dernière soit plus grande sous l'électrode de drain D que sous l'électrode de source S; l'électrode de grille G est placée à la limite entre les deux parties d'épaisseurs différentes de cette couche. Dans une variante, l'électrode de grille forme un contact Schottky avec la couche.

Application : amplificateurs pour hyperfréquences en télécommunication notamment.

EP 0 030 178 A2

1

# TRANSISTOR A EFFET DE CHAMP, PROCEDE DE FABRICATION DE CELUI-CI, ET AMPLIFICATEUR COMPRENANT UN TEL TRANSISTOR

L'invention concerne un transistor à effet de champ.

D'une façon générale, les transistors à effet de champ (TEC ou FET, dans la terminologie anglo-saxonne) comportent, sur un substrat semiconducteur, trois électrodes successives de source, de grille et de drain, entre lesquelles, en fonctionnement, sont établies des différences de potentiel ; sous l'effet de celles-ci, a lieu dans le substrat le déplacement de charges électrisées libres de la source vers le drain. Ce déplacement se fait sous les électrodes parallèlement à la direction dans laquelle sont alignées ces électrodes, dans une région usuellement appelée "canal", située à une certaine distance sous les électrodes. Cette région présente une épaisseur qui varie de l'une à l'autre de ses extrémités, entre la source et le drain, avec un net rétrécissement dans sa partie terminale, c'est-à-dire entre la grille et le drain, dans les conditions habituelles de fonctionnement. Pour plus de précisions sur ce fonctionnement, on se reportera notamment à l'article de Litchi "Microwave Field Effect Transistors", 1976, IEEE trans. MTT 24, n° 6, juin 1976.

Cette région résulte des conditions de champ électrique régnant sous la diode formée par la grille polarisée en inverse, en relation avec la zone désertée créée sous celle-ci par la différence de potentiel appliquée. Une zone à fort champ électrique s'établit vers l'extrémité de la grille du côté du drain où l'essentiel de la différence de potentiel drain-source se manifeste. Avec les substrats d'épaisseur constante utilisés très généralement, ceci a pour effet le rétrécis sement mentionné. Ce phénomène est particulièrement marqué dans le cas de l'arséniure de gallium, l'un des matériaux utilisés pour constituer les substrats, auquel l'invention n'est cependant pas limitée ; l'invention couvre également le cas des autres matériaux utilisables à cette fin, silicium et phosphure d'indium, InP, notamment.

Or, l'existence d'un fort champ électrique entre grille et drain limite la différence de potentiel que l'on peut appliquer au drain par rapport à la source sans provoquer de "claquage" drain-source et,

2

par la-même, la puissance du dispositif. On a proposé, pour résoudre cette difficulté, d'adopter une structure à paliers dans laquelle le substrat présentait une épaisseur plus grande à l'endroit du drain et où l'électrode de grille était posée sur le palier inférieur portant aussi l'électrode de source (voir "Improvment of the Drain Breakdown Voltage of GaAs Power MESFET's by a Simple Recess Structure" IEEE Trans. Electron Device, vol. ED-25, n° 6, juin 1978 par Takashi Furutsuka et al.)

Selon l'invention, la dimension de la zone active sous la grille est rendue croissante de la source vers le drain, par modification de l'interface entre cette zone active et le reste du substrat. L'augmentation du potentiel drain-source est ainsi rendue compatible avec une épaisseur de canal pratiquement constante sous la grille. Le champ électrique sous la grille, responsable du mouvement des charges libres, est maintenu à peu près constant tout le long de la grille ; des tensions drain-source plus élevées et des puissances plus fortes sont de ce fait possibles, toutes choses égales par ailleurs.

Le temps de transit des charges libres sous la grille se trouve d'ailleurs en même temps diminué, ce qui permet des fréquences de fonctionnement plus élevées et un gain amélioré.

L'invention sera mieux comprise en se reportant à la description qui suit et aux figures jointes qui représentent.:

- figures 1(a) et (b) : des vues schématiques d'un transistor à effet de champ de l'art antérieur ;

- figure 2 : une vue explicative concernant le transistor des figures précédentes ;

- figures 3, 4 et 5 : des vues schématiques en coupe de diverses variantes du transistor à effet de champ de l'invention ;

- figure 6 : une description des étapes de réalisation d'un transistor conforme à la figure 4.

Afin de fixer les idées, on procède ci-dessous à un bref retour sur la structure générale d'un transistor à effet de champ.

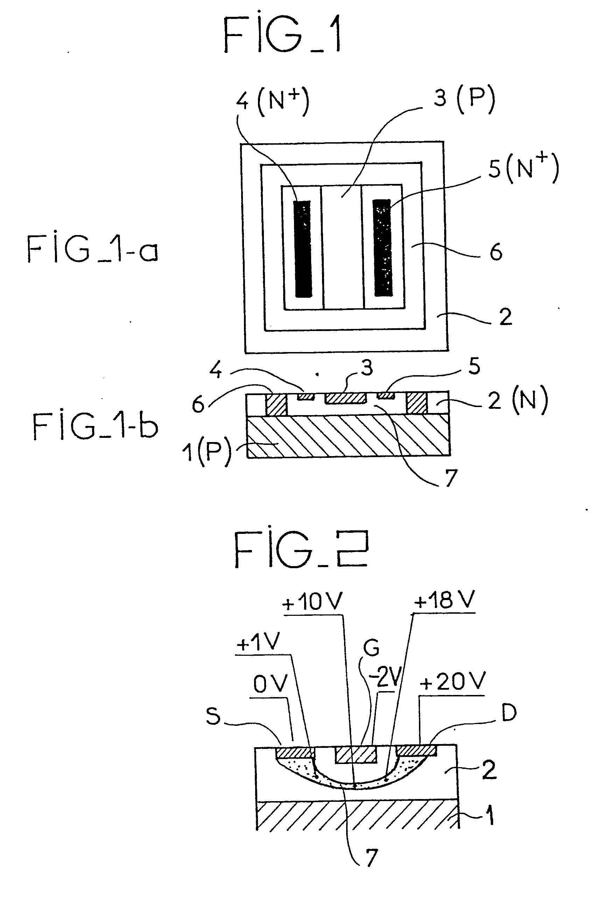

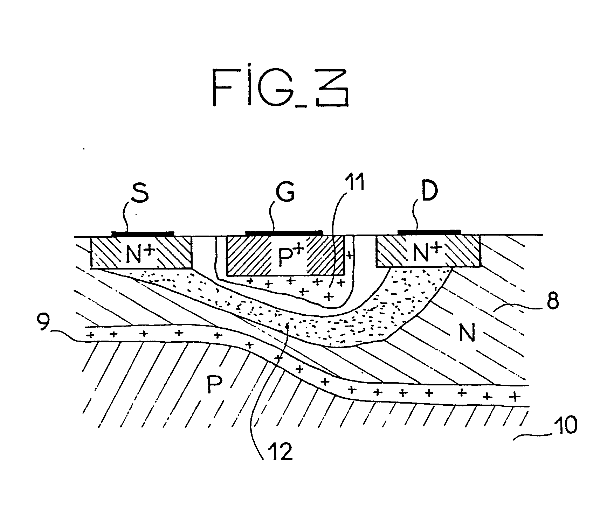

Il s'agit ici d'un transistor à jonctions, mais le principe est équivalent pour ce qui concerne les autres types de transistors à effet de champ, tels que ceux à barrière Schottky (MESFET). Un tel transistor comporte, sur un substrat semi-conducteur d'un type donné, une couche de type opposé ; dans cette couche est réalisée locale-ment (par diffusion ou implantation par exemple) une zone de même type que le substrat, généralement le long d'une bande, reliée électriquement au substrat. A la surface de cette zone est déposée une électrode (appelé "grille" et désignée par G) réalisant un contact ohmique avec cette dernière. De part et d'autre de celle-ci sont également déposées deux autres électrodes (appelées "source" et "drain", respectivement désignées par S et D) réalisant des contacts ohmiques avec la couche de type opposé à celui du substrat, par l'intermédiaire de deux zones de même type que cette couche mais plus fortement dopées. La figure 1 (a et b) illustre, en plan et en coupe, un tel transistor. Sur cette figure en 1 est représenté le substrat, de type P dans l'exemple, en 2 la couche de type opposé N qui le recouvre et en 3 la bande en question de même type que le substrat, c'est-à-dire le type P. Les repères 4 et 5, représentés par des traits noirs épais, désignent les contacts de source et de drain. On appelle canal la portion de la zone N située sous la grille, à l'intérieur de laquelle circulent les charges, de la source vers le drain. Son épaisseur est contrôlée par le potentiel appliqué sur la grille. Le canal, dont le contour sera précisé plus loin, porte le repère 7. Dans l'exemple de la figure on aperçoit en plus, un caisson 6 isolant le transistor du reste de la pièce, et constitué d'une couche de type P comme le substrat. La vue en coupe montre les épaisseurs respectives des éléments : la partie diffusée 3, ainsi que les contacts 4 et 5 ne s'étendent dans la couche 2 que sur une fraction de sa profondeur, alors qu'au contraire le caisson 6 la traverse dans toute son épaisseur. La diffusion 3, qui rejoint le caisson à ses deux extrémités, est en contact électrique avec celui-ci et par son intermédiaire avec le substrat.

En fonctionnement, une différence de potentiel est appliquée entre le drain et la source, rendant le drain positif par rapport à la source, par exemple de +20 V, la grille étant, dans un mode courant

4

de fonctionnement de ce genre de transistor, portée à un potentiel légèrement négatif par rapport à celui de la source, prise comme référence. La figure 2, en coupe, montre, sur un exemple, les valeurs des potentiels appliqués aux électrodes et la répartition approxi mative correspondante des potentiels le long du canal ; elle montre aussi le contour du canal en question (surface couverte de points), dans lequel circulent les charges libres, des électrons dans le cas de l'exemple. Sur la figure les trois électrodes de source, de grille et de drain, ont été désignées par leurs initiales S, G, D. La même figure montre que la zone désertée au-dessus du canal, sous la grille, a une dimension qui va en croissant vers le drain.

Afin que l'augmentation de la dimension de cette zone comme indiqué, c'est-à-dire en gros perpendiculairement au trajet. des électrons, n'amène pas le rétrécissement, localisé à l'extrémité de la grille, observé dans l'art antérieur, l'interface entre la zone active et le substrat est réalisée à une profondeur variable sous la grille, telle que l'épaisseur de ladite zone active aille en croissant de la source vers le drain.

La figure 3 montre un exemple de réalisation conforme à l'invention. La couche 8 de type N, dans laquelle est située la zone active, a une interface 9 (croix) avec le reste du substrat 10, de type P, située à une profondeur qui varie entre source et drain de telle sorte que ladite zone active ait une épaisseur croissante de la source vers le drain. Ce résultat peut être obtenu, par exemple, grâce à deux opérations successives de diffusion, la première localisée du côté drain, et la suivante réalisée sur l'ensemble de la surface. Dans la couche 8 sont réalisées des zones dopées sans repères $N^+$, $P^+$ et $N^+$ de source, de grille et de drain, comme le montre le dessin. La zone 11 remplie de croix, montre la zone désertée lorsque, en fonctionnement normal, la grille est polarisée en inverse. Le canal 12 sous la grille, peut avoir ainsi une largeur à peu près constante pour les conditions nominales de fonctionnement, ce qui permet d'éviter d'avoir une zone très localisée à très fort champ électrique. Il est alors possible d'appliquer une tension plus élevée entre drain et source, ce qui permet l'obtention de puissances plus grandes.

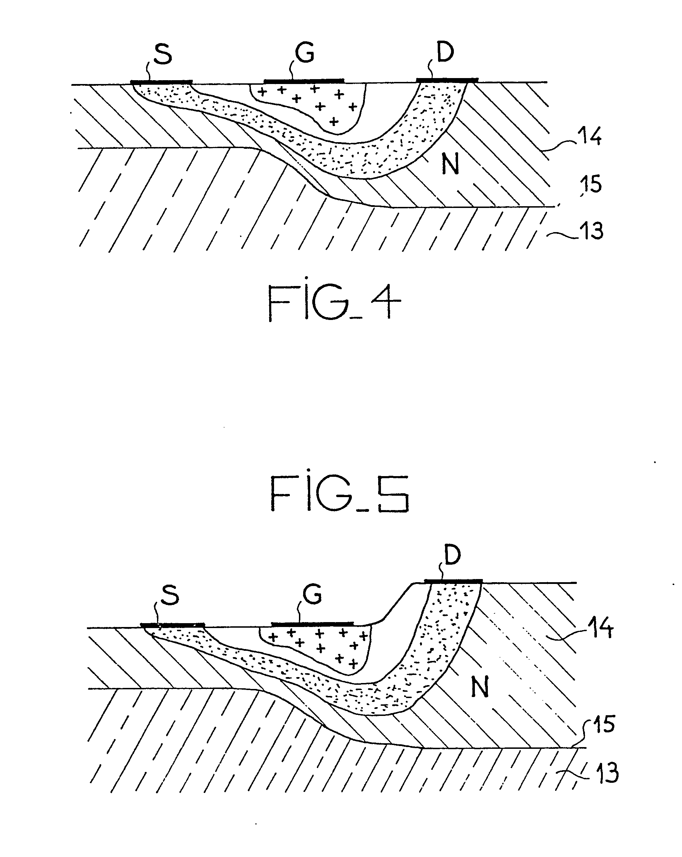

Les figures 4 et 5 montrent des coupes de transistors à grille Schottkty conformes à l'invention. Le substrat 13 est isolant par exemple en verre,ou semi-isolant, par exemple en arséniure de gallium compensé. A la surface de ce dernier est réalisée une zone dopée 14 de type N. Les électrodes de source et de drain, ont un contact de type ohmique avec cette zone. L'électrode de grille constitue une barrière Schottky. Cette zone dopée, qui contient la zone active, a une interface 15 avec le reste du substrat située à une profondeur qui varie de telle sorte que ladite zone active ait une épaisseur croissante de la source vers le drain. Une telle configuration peut être obtenue par implantation. On sait, actuellement, réaliser des transistors à grille Schottky où la zone dopée est obtenue par implantation.

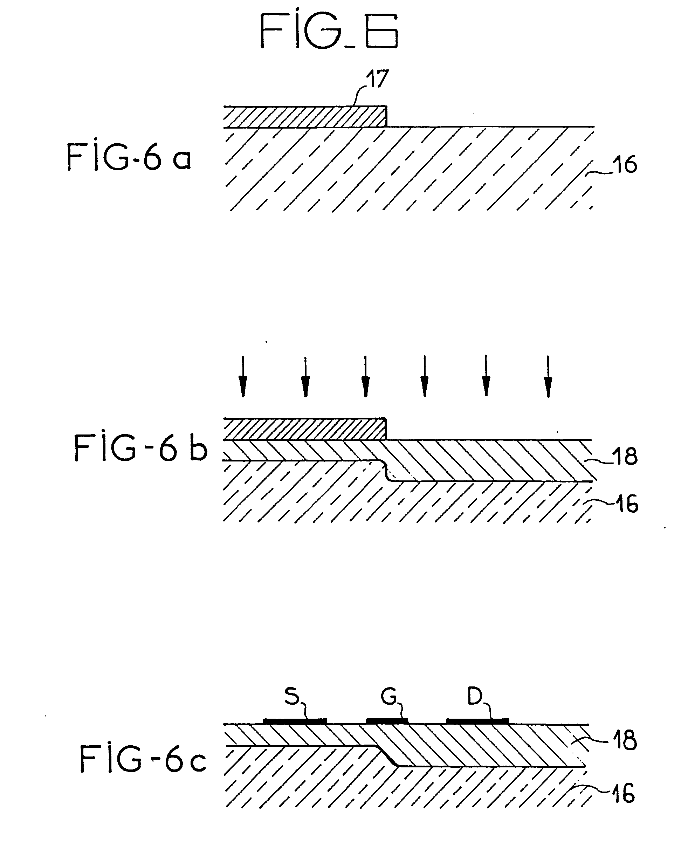

La figure 6 montre schématiquement une suite d'opérations permettant d'obtenir une configuration conforme à la figure 4. Sur un substrat 16 en arséniure de gallium semi-isolant, on dépose (figure 6a) une marche 17 d'un matériau dont l'épaisseur est contrôlée avec une bonne précision. Ce matériau pourra être de l'aluminium, et la marche sera obtenue par gravure suivant une technique connue. On soumet la surface ainsi obtenue à un bombardement ionique (flèches figure 6b). Il pourra s'agir d'ions soufre, ou plus avantageusement d'ions silicium, accélérés à des énergies de l'ordre de 200 à 300 keV. Il seforme ainsi une couche dopée de type N (18) dont l'interface avec le reste du substrat reflète la présence de la marche d'aluminium. Suivant une technique connue de l'art on peut avantageusement effectuer une autre implantation, à une énergie plus faible, par exemple 70 keV, pour apporter des modifications du second ordre au profil de dopage dans la zone qui n'est pas recouverte d'aluminium. La marche d'aluminium est ensuite enlevée par attaque chimique et l'on procède à un recuit. On dépose ensuite (figure 6c), les électrodes de source et de drain en alliage or-germanium-nickel par exemple, pour établir un contact ohmique. La grille est obtenue après masquage électronique par évaporation

6

d'aluminium pour obtenir un contact Schottky.

Une attaque chimique localisée, avant dépôt des électrodes, permet, éventuellement, d'obtenir la configuration de la figure 5, particulièrement favorable à la collection des charges, avec une face libre, celle qui porte les électrodes, en gradin.

En pratique, on loge sur un même substrat d'un millimètre carré de surface, ou de cet ordre, des batteries de transistors tels que celui décrit ci-dessus. Ces transistors sont montés en parallèle pour l'amplification en hyperfréquence, dans les dispositifs de télé communication notamment, sur des fréquences allant jusqu'à 20 gigahertz.

L'invention couvre non seulement les variantes décrites, mais aussi toutes les autres variantes accessibles à l'homme de l'art à partir de celles décrites.

7

# R E V E N D I C A T I O N S

1. Transistor à effet de champ, constitué d'un substrat (10) et, sur ce substrat, d'une couche (8) d'un corps semiconducteur dopé, de type donné, sur lequel sont disposées, alignées, les électrodes de source (S) de grille (G) et de drain (D)du transistor, caractérisé en ce que l'interface (9) entre le substrat et la couche présente une marche, de telle sorte que ladite couche ait une épaisseur plus grande sous l'électrode de drain que sous l'électrode de source,et qui aille en croissant sous l'électrode de grille, de la source vers le drain.

2. Transistor à effet de champ suivant la revendication 1, caractérisé en ce que, le substrat consistant en un semi-conducteur dopé, de type opposé à celui de la couche, les électrodes consistent en des zones dopées formées dans la couche de semiconducteur, de même type que cette couche, et à plus fort dopage pour la source et le drain, et en une zone dopée de type opposé à celui de la couche pour la grille.

3.Transistor à effet de champ suivant la revendication 1, caractérisé en ce que, le substrat consistant en un isolant, les électrodes consistent en des parties métalliques appliquées sur la couche formant, sur celle-ci contact ohmique, pour la source et le drain, et barrière Schottky pour la grille.

4.Transistor à effet de champ suivant la revendication 3, caractérisé en ce que le substrat est un semi-conducteur compensé.

5.Procédé de réalisation du transistor à effet de champ selon la revendication 1 ou la revendication 4, caractérisé en ce qu'il comporte notamment les opérations suivantes :

a) dépôt sur l'une des faces, plane, d'un substrat semi-conducteur (16) d'une marche (17) en métal sur une épaisseur controlée (figure 6a);

b) bombardement de cette face par un flux d'ions accélérés vers celle-ci avec une énergie assurant leur implantation dans le substrat (figure 6b);

c) élimination de la marche en métal ;

d) réalisation sur cette face de trois électrodes, de source (S), de grille (G) et de drain (D) (figure 6c).

6. Procédé suivant la revendication 5, caractérisé en ce qu'il comporte, après l'opération c) une attaque chimique de cette face à l'emplacement de cette marche.

7. Procédé suivant la revendication 5, caractérisé en ce que le substrat est fait d'arsénuire le gallium semi-isolant et le flux, d'ions de silicium.

8. Procédé suivant la revendication 5, caractérisé en ce que l'opération d) consiste en :

I. Un dépôt sur cette face de contacts ohmiques, l'un sur la partie de celle-ci où se trouvait initialement la marche, l'autre sur l'autre partie ;

II. Un dépôt sur la même face d'une électrode métallique formant barrière Schottky avec cette face, à la limite entre ces deux parties.

9. Amplificateur pour hyperfréquences, caractérisé en ce qu'il comprend au moins un transistor à effet de champ suivant l'une des revendications 1, 2, 3 ou 4.

# FIG_1

FIG_1-a

$4(N^+)$    $3(P)$

$5(N^+)$

6

2

FIG_1-b

4   3   5

6    $2(N)$

$1(P)$

7

# FIG_2

+10V    +18V

+1V    G   

0V    -2V    +20V

S           D

2

1

7

# FÍG_3

FIG_4

FIG_5

4/4

# FÍG_6

FÍG-6 a

17

16

FÍG-6 b

18

16

FÍG-6 c

S   G   D

18

16